(19) Europäisches Patentamt
European Patent Office
Office européen des brevets

(11) **EP 2 921 467 B1**

(12) **EUROPEAN PATENT SPECIFICATION**

(45) Date of publication and mention
of the grant of the patent:
**06.02.2019 Bulletin 2019/06**

(51) Int Cl.:
***C04B 35/453*** *(2006.01)*      ***C23C 14/34*** *(2006.01)*
***H01L 31/06*** *(2012.01)*

(21) Application number: **13855320.1**

(22) Date of filing: **18.11.2013**

(86) International application number:
**PCT/JP2013/081062**

(87) International publication number:
**WO 2014/077395 (22.05.2014 Gazette 2014/21)**

(54) **OXIDE SINTER, SPUTTERING TARGET USING SAME, AND OXIDE FILM**

OXIDSINTER, SPUTTERTARGET DAMIT UND OXIDFOLIE

SINTER D'OXYDE, CIBLE DE PULVÉRISATION L'UTILISANT ET FILM D'OXYDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.11.2012 JP 2012253473**

(43) Date of publication of application:
**23.09.2015 Bulletin 2015/39**

(73) Proprietor: **Tosoh Corporation
Syunan-shi, Yamaguchi 746-8501 (JP)**

(72) Inventors:
• **AKIIKE, Ryo
Ayase-shi, Kanagawa 252-1123 (JP)**

• **KURAMOCHI, Hideto
Ayase-shi, Kanagawa 252-1123 (JP)**
• **TAMANO, Kimiaki
Ayase-shi, Kanagawa 252-1123 (JP)**

(74) Representative: **Müller-Boré & Partner
Patentanwälte PartG mbB
Friedenheimer Brücke 21
80639 München (DE)**

(56) References cited:
**WO-A1-2007/141994      WO-A1-2009/110093
WO-A1-2012/077512      JP-A- 2009 132 998
JP-A- 2009 249 187      JP-A- 2009 263 709
JP-A- 2012 106 880      JP-A- 2012 197 215**

**Description**

The present invention relates to an oxide sintered body, a sputtering target using it, and an oxide film.

Compound semiconductor-type thin film solar cells using, as a light-absorbing layer, a compound p-type semiconductor thin film composed of Group Ib element, Group IIIb element and Group VIb element, such as a $CuInSe_2$ film (hereinafter sometimes referred to as a CIS film), a $Cu(In, Ga)Se_2$ film (hereinafter sometimes referred to as a CIGS film) or a Cu (Zn, Sn)S (or Cu(Zn, Sn)Se) film (hereinafter sometimes referred to as a CZTS film) (the solar cells using the above-exemplified compound semiconductor thin films may be hereinafter sometimes referred to as CIS, CIGS and CZTS solar cells, respectively) have attracted much attention, since they exhibit high energy conversion efficiency and undergo no deterioration of the conversion efficiency by the external environment.

However, in order to reduce the power generation cost, further improvement of the conversion efficiency is required. As one effective approach for improvement of the conversion efficiency, control of the electron state at an interface between a p-type semiconductor thin film layer and a n-type semiconductor layer is known.

For example, Patent Document 1 proposes a thin film solar cell employing a film having an alkaline earth metal element added to an n-type semiconductor layer. A method of employing a sputtering method is exemplified therein as its means, but with respect to the sputtering method, no disclosure is made about the physical properties or production method for a sintered body to be used for the sputtering target. It is known that in a sputtering method, sputtering properties may vary substantially depending upon the physical properties of a sintered body to be used as the sputtering target, and due to abnormal electrical discharge or generation of particles, a damage to the substrate may result, which remarkably deteriorates the properties of a device such as a solar cell and should therefore be precisely controlled.
JP 2009-132998 A describes a sputtering target of ZnO and a manufacturing method thereof.

Patent Document 1: JP-A-2003-197935

It is an object of the present invention to provide an oxide sintered body for a sputtering target, which is capable of adding specific elements to from an n-type semiconductor layer to a p-type semiconductor layer surface of a compound thin-film solar cell.

In view of the above background, the present inventors have conducted an extensive study and, as a result, have found that at the time of forming an n-type semiconductor film on a p-type compound semiconductor film, by adding specific elements to the n-type semiconductor layer by sputtering, it is possible to improve the bonding state to cause a phenomenon of e.g. improving the life-time of a carrier formed during light irradiation and thereby to increase the conversion efficiency, and thus, they have accomplished the present invention.

That is, the present invention provides an oxide sintered body, a sputtering target using it, and an oxide film, having the following characteristics.

(1) An oxide sintered body which contains zinc (Zn) and magnesium (Mg) and at least one type of element (X) that has an ionization potential Ip of 4.5 eV$\leqq$Ip$\leqq$8.0 eV and an atomic radius d of 1.20 Å$\leqq$d$\leqq$2.50 Å and which has a sintered density of at least 95%, wherein the element X is at least one element selected from the group consisting of Li, Ca, Sc, Ti, Sr, Y, Zr, Nb, La, Ce, Nd, Sm, Eu, Ho, Hf, Ta, W and Bi in the following composition ratios (atomic ratios):

$$0.0001 \leq X/(Zn+Mg+X) \leq 0.01$$

$$0.0002 \leq (Mg+X)/(Zn+Mg+X) \leq 0.20.$$

(2) A sputtering target using the sintered body as defined in the above (1).
(3) An oxide thin film obtainable by using the sputtering target as defined in the above (2).
(4) A photoelectric conversion element which is a solar cell having a light-absorbing layer being a p-type semiconductor, and a n-type semiconductor layer, wherein the n-type semiconductor layer is the oxide thin film as defined in the above (3).
(5) A method for producing the photoelectric conversion element as defined in the above (4), which comprises forming the n-type semiconductor layer by using the sintered body as defined in the above (2) as a sputtering target.

The oxide sintered body of the present invention is useful as a sputtering target for the preparation of an n-type semiconductor layer in a solar cell.

By conducting film deposition by using the oxide sintered body of the present invention as a sputtering target, it becomes possible to prepare an n-type semiconductor layer to form a good p-n junction with a p-type semiconductor layer and thereby to improve the conversion efficiency of the solar cell.

Fig. 1 is a cross-sectional view of the main portion of a solar cell, to which the present invention is suitably applicable.

Fig. 2 is a cross-sectional view of the main portion of a solar cell prepared in Examples of the present invention.

Now, the details of the present invention will be described. The present invention provides an oxide sintered body containing specific elements, which is useful for a sputtering target.

In the present invention, the oxide sintered body contains element (X) that has an ionization potential Ip of 4.5 eV$\leq$Ip$\leq$8.0 eV and an atomic radius d of 1.20 Å$\leq$d$\leq$2.50 Å in the specific composition ratio (atomic ratio) defined below. With respect to the ionization potential, the values in the data base "Ground levels and ionization energies for the neutral atoms" published by National Institute of Standards and Technology (NIST), USA, may be referred to.

Further, the atomic radius d in the present invention represents the size of an atom in a state which is independent and not electrically charged i.e. the size of an atom when it is not influenced by a bonding state of electrons, and the values disclosed in a literature, E Clementi, DL Raimondi, WP Reinhardt, J. Chem. Phys. 38 (1963), 2686, may be referred to.

In the oxide sintered body of the present invention, the composition ratio (atomic ratio) of element X is preferably 0.10$\leq$X/(Zn+X)$\leq$0.20, further preferably 0.15$\leq$X/(Zn+X)$\leq$0.20. Such a composition is preferred, since it exhibits a high transmittance to sunlight, has a high electrical resistance and forms a good p-n junction with a p-type semiconductor layer, at the time when the oxide sintered body of the present invention is used for a n-type semiconductor layer.

Further, as the element X, at least one element selected from the group consisting of Li, Ca, Sc, Ti, Sr, Y, Zr, Nb, La, Ce, Nd, Sm, Eu, Ho, Hf, Ta, W and Bi is used. Among these elements X, a solar cell prepared by using the present invention to contain an element having an ionization potential of 5 eV$\leq$Ip$\leq$7.5 eV and an ionic radius of 1.30 Å$\leq$d$\leq$2.35 Å tends to exhibit higher conversion efficiency. Particularly, a solar cell prepared by using the present invention to contain an element having an ionization potential of 5.5 eV$\leq$Ip$\leq$7.3 eV and an ionic radius of 1.70 Å$\leq$d$\leq$2.35 Å tends to exhibit further higher conversion efficiency.

According to the present invention, the oxide sintered body contains magnesium (Mg). Further, it is preferred to contain Mg in a composition ratio (atomic ratio) of 0.0001$\leq$Mg/(Zn+Mg+X)<0.20. According to the present invention, the oxide sintered body further contains at least one element X selected from the group consisting of Li, Ca, Sc, Ti, Sr, Y, Zr, Nb, La, Ce, Nd, Sm, Eu, Ho, Hf, Ta, W and Bi in a composition ratio (atomic ratio) of 0.0001$\leq$X/(Zn+Mg+X)$\leq$0.01.

Among the above elements X, a solar cell prepared by using the present invention to contain an element having an ionization potential of 5 eV$\leq$Ip$\leq$7.5 eV and an ionic radius of 1.30 Å$\leq$d$\leq$2.35 Å tends to exhibit higher conversion efficiency. Particularly, a solar cell prepared by using the present invention to contain an element having an ionization potential of 5.5 eV$\leq$Ip$\leq$7.3 eV and an ionic radius of 1.70 Å$\leq$d$\leq$2.35 Å tends to exhibit further higher conversion efficiency. Among these elements X satisfying such physical properties, it is more preferred to use rare earth elements, since it is thereby possible to increase the amount of electrical current which can be taken out from sunlight. Among such rare earth elements, it is further preferred to use Eu, Nd or Ho, since it is thereby possible to prepare a solar cell having high conversion efficiency and a large amount of electrical current which can be taken out from sunlight.

According to the present invention, the composition contains Mg. If the amount of element X added becomes 0.01<X/(Zn+Mg+X), such may adversely influence the electrical resistance and the transmittance of a film obtainable by film deposition and may finally deteriorate the conversion efficiency of the solar cell performance. In the present invention, it is characterized that the sintered density of the sintered body is at least 95%, preferably at least 98%. Otherwise, if film deposition of an n-type semiconductor layer is conducted by using a sintered body having a low sintered density, not only it becomes difficult to carry out the film deposition stably due to formation of particles or nodules, or high incidence of abnormal electrical discharges, but also localization of in-plane distribution of the film composition, damages to a solar cell element during film deposition, etc. are likely to occur, thus leading to deterioration of the solar cell performance.

The oxide sintered body of the present invention can be used suitably as a sputtering target. The oxide sintered body may be used as it is, as a sputtering target, or the oxide sintered body may be processed into a predetermined shape and then be used as a sputtering target.

At that time, the sputtering target preferably has a surface roughness of the sputtering surface of at most 3 $\mu$m, more preferably at most 2 $\mu$m, by center line average roughness (Ra). It becomes thereby possible to further control the number of abnormal discharge times at the time of forming the n-type semiconductor layer and to realize stabilized film formation. The center line average roughness may be adjusted by a method of mechanically processing the sputtering surface of the oxide sintered body by means of grinding stones of different counts, a method of jet-processing it by sand blasting, etc. Further, the center line average roughness may be obtained, for example, by evaluating the measurement surface by a surface state measuring device.

The oxide thin film obtained by using such a sputtering target is suitable as an n-type semiconductor layer in a solar cell. Such an n-type semiconductor layer has a role as an interlayer to prevent short-circuiting of an upper electrode and a lower electrode and thus is required to have a high electrical resistance. A preferred electrical resistance is at least 1.0E+8Ω/□, more preferably at least 1.0E+9Ω/□, most preferably at least 1.0E+10Ω/□.

In addition, the n-type semiconductor layer plays a role as a window to pass light to the p-type semiconductor layer and thus is required to have a high transmittance over optically wide wavelengths. Specifically, when formed on a glass substrate, it preferably has a transmittance of at least 80% at wavelengths of from 450 to 800 nm and has a transmittance of at least 85% at wavelengths of from 800 to 1,200 nm, in a state including the substrate. More preferably, it has a transmittance of at least 82% at wavelengths of from 450 to 800 nm and has a transmittance of at least 88% at wavelengths of from 800 to 1,200 nm.

Here, the transmittance is a value obtained by dividing the amount of light passed through a test sample by the amount of light entered and is defined by the following formula.

$$\text{Transmittance (\%)} = (\text{amount of light passed/amount of light entered}) \times 100$$

The production method for the oxide thin film may suitably be selected from a DC sputtering method, a RF sputtering method, an AC sputtering method, a DC magnetron sputtering method, a RF magnetron sputtering method, an AC magnetron sputtering method, an ion beam sputtering method, etc. Particularly from such a viewpoint that uniform and high speed film deposition over a large area is possible, a DC magnetron sputtering method, a RF magnetron sputtering method or an AC magnetron sputtering method is preferred.

The temperature of the substrate at the time of film deposition is not particularly limited, but in consideration of an influence to a solar cell substrate, it is preferred to carry out the film deposition at a low temperature as far as possible, and it is particularly preferred to carry out it without heating. Because, an increase of the substrate temperature is likely to bring about diffusion of various elements constituting a solar cell and thus to bring about deterioration of the conversion efficiency.

As the atmosphere gas during the sputtering, usually, an inert gas, such as argon gas, may be used. As the case requires, oxygen gas, nitrogen gas or hydrogen gas may, for example, be used.

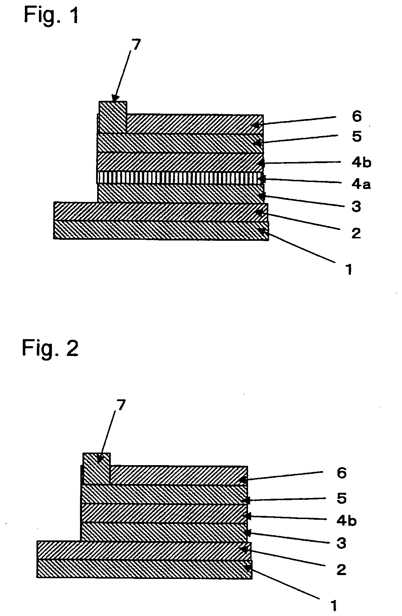

An example of a solar cell wherein the above-described oxide thin film is used, will be described, but the solar cell wherein the present invention is useful, is not limited thereto. Fig. 1 shows a cross-sectional view of a solar cell. The solar cell in Fig. 1 comprises a substrate 1, a lower electrode film 2, a semiconductor layer 3 (a second semiconductor layer), an n-type buffer layer 4a, an n-type semiconductor layer 4b (a first semiconductor layer), an upper electrode film 5 and an antireflective film 6, sequentially formed on the substrate, and an extraction electrode 7 formed on the upper electrode film 5. That is, the semiconductor layer 4b is disposed on the light incidence side than the semiconductor layer 3.

As the substrate 1, glass, stainless steel or a polyimide film may, for example, be used.

As the lower electrode film 2, a metal film made of Mo may, for example, be used.

The semiconductor layer 3 (the second semiconductor layer) is a semiconductor layer functioning as a light-absorbing layer and is a p-type semiconductor layer. The semiconductor layer 3 is disposed on the back side than the semiconductor layer 4b.

As the semiconductor layer 3, a compound semiconductor layer containing Group Ib element, Group IIIb element and Group VIb element, may, for example, be used, and it is possible to use, for example, $CuInSe_2$, $Cu(In, Ga)Se_2$, $CuInS_2$ or $Cu(In, Ga)S_2$. Further, the semiconductor layer 3 may be provided with a surface semiconductor layer at the surface on the semiconductor 4 side (the same applies to the following embodiment). Here, the surface semiconductor layer is an n-type semiconductor layer or a high resistance (resistance of at least $10^4 \Omega cm$) semiconductor layer. As the high resistance semiconductor layer, $CuIn_3Se_5$ or $Cu(In, Ga)_3Se_5$ may, for example, be mentioned.

The semiconductor layer 4b (the first semiconductor layer) is a layer to form a p-n junction together with the semiconductor layer 3 and functions as a window layer. The semiconductor layer 4b is an n-type semiconductor layer. As the semiconductor layer 4b, it is possible to use a compound containing, as the main component (content of at least 70 at%), zinc oxide represented by the general formula $Zn_{1-a}X_aO$ (containing at least one type of element X having an ionization potential Ip of 4.5eV≦Ip≦8.0eV and an atomic radius d of 1.20 Å≦d≦2.50 Å in a composition ratio (atomic ratio) of 0.0001≦X/(Zn+X)≦0.20).

The upper electrode film 5 is a transparent conductive film, and it is possible to use, for example, ZnO:Al having Al doped on ZnO, ZnO:Ga having Ga doped on ZnO, or ITO (Indium Tin Oxide).

The antireflective film 6 is a film to prevent incidence light from reflecting at an interface with the upper electrode 5, and it is possible to use, for example, $MgF_2$ when the upper electrode film 5 is ITO, ZnO:Al or ZnO:Ga.

As the extraction electrode 7, it is possible to use, for example, a metal film having NiCr and Au co-vapor deposited.

Now, an example of a production method for a solar cell will be described. Firstly, on a substrate 1, the lower electrode film 2 is formed by e.g. a sputtering method or a vapor deposition method. Then, on the lower electrode film 2, the semiconductor layer 3 is formed by e.g. a vapor deposition method or a sputtering method. Then, on the semiconductor layer 3, the n-type semiconductor layer 4b is formed by e.g. a chemical deposition method or a sputtering method.

Then, on the n-type semiconductor layer 4b, the upper electrode film 5 is formed by e.g. a sputtering method. Then, on a part of the upper electrode film 5, the extraction electrode 7 is formed by e.g. an electron beam vapor deposition method. Then, on the upper electrode film 5, the antireflective film 6 is formed by e.g. a vapor deposition method. In this manner, a solar cell can be formed. Further, in a case where a high resistance n-type buffer layer 4a is to be formed on the surface of the semiconductor layer 3, it may be formed by e.g. a solution dipping method, a vapor deposition method or a vapor-phase diffusion method.

In the present invention, the method for producing an n-type semiconductor layer by sputtering may suitably be selected from a DC sputtering method, a RF sputtering method, a AC sputtering method, a DC magnetron sputtering method, a RF magnetron sputtering method, a AC magnetron sputtering method, an ion beam sputtering method, etc. Particularly from such a viewpoint that uniform and high speed film deposition over a large area is possible, a DC magnetron sputtering method, a RF magnetron sputtering method or an AC magnetron sputtering method is preferred. Since high energy particles formed by such sputtering play a role for film deposition, it becomes possible to form a junction with the n-type semiconductor layer from a site relatively deep in the p-type semiconductor surface. However, if a sputtering condition for excessively high energy is used, there may be a case where deterioration in the solar cell properties is brought about.

Single sputtering is preferred wherein as the target to be used, a unitary target containing desired elements and having a specific composition, is used. The temperature of the substrate at the time of film deposition is not particularly limited, but when an influence to the solar cell substrate is taken into consideration, it is preferred to conduct the film deposition at a low temperature as far as possible, and it is more preferred to conduct it without heating. Because, an increase of the substrate temperature is likely to bring about diffusion of various elements constituting a solar cell and thus to bring about deterioration of the conversion efficiency. As the atmosphere gas during the sputtering, usually, an inert gas, such as argon gas, may be used. As the case requires, oxygen gas, nitrogen gas or hydrogen gas may, for example, be used.

Now, the production method for the oxide sintered body of the present invention will be described in detail.

That is, the production method of the present invention comprises (1) a step of preparing a powder for molding by mixing a powder of the zinc compound and powders of other compounds in a predetermined atomic ratio, a step of preparing a green body by molding the powder for molding, and a step of preparing a sintered body by firing the green body.

Now, the respective steps will be described in detail.

(1) Powder preparation step

Raw material powders of respective elements are not particularly limited, and it is possible to use, for example, metal oxide powders, metal hydroxide powders, metal salt powders of e.g. chlorides, nitrates, carbonates, etc., metal alkoxides, etc. However, in consideration of handling efficiency, metal oxide powders are preferred. Further, in the present invention, in a case where other than metal oxide powders are used, such powders may preliminarily be subjected to heat treatment, etc. in an oxidizing atmosphere of e.g. atmospheric air to be converted to metal oxide powders which may be used to obtain the same effects. If an operation for heat treatment or the like is involved, the process tends to be cumbersome, and therefore, it is particularly preferred to use metal oxide powders as raw material powders. Further, in a case where metal oxide powders are poor in stability, particularly when elements such as Li, Mg and Ca are to be incorporated, it is more preferred to use carbonates in consideration of handling efficiency.

Now, description will be made primarily with reference to a case where metal oxide powders and carbonate powders are used. The particle size of the metal oxide powders as the raw material powders should better be fine, since the uniformity in a mixed state and the sinterability are thereby excellent. Therefore, usually a powder of at most 10 $\mu$m as a primary particle size, is preferably employed, and a powder of at most 1 $\mu$m is particularly preferably employed. As powders of elements other than zinc, it is preferred to employ powders having a primary particle size smaller than the primary particle size of zinc oxide powder. If the primary particle size of zinc oxide powder is smaller or equal, the uniformity in the mixed state is likely to be poor.

Further, with respect to average particle sizes, it is preferred that the average particle size of zinc oxide powder is larger than the average particle size of metal oxide powders other than zinc. It is thereby possible to uniformly mix raw material powders and to obtain an oxide sintered body of the present invention composed of particles having a fine average particle size.

Further, the BET specific surface area of zinc oxide powder and metal oxide or carbonate powder other than zinc, is preferably from 3 to 20 $m^2$/g in consideration of handling efficiency, whereby it becomes easy to obtain an oxide sintered body of the present invention. In the case of a powder having a BET value smaller than 3 $m^2$/g, it is preferably pulverized to a powder having a BET value of from 3 to 20 $m^2$/g, which is then used. It is also possible to use a powder having a BET value larger than 20 m$^2$/g, but the powder tends to be bulky, and therefore, it is preferred to preliminarily carry out compaction treatment of the powder in order to improve the handling efficiency. With such powder characteristics, it is possible to suitably obtain the oxide sintered body of the present invention.

The method for mixing these powders is not particularly limited, and a mixing method such as a dry or wet media stirring mill by means of balls or beads made of zirconia, alumina, nylon, etc., media-less container rotational mixing, or mechanical stirring mixing, may be exemplified. Specifically, a ball mill, a beads mill, an attritor, a vibration mill, a planetary mill, a jet mill, a V-type mixer, a paddle mixer, a twin screw planetary mill, etc. may be mentioned.

Further, at the same time as mixing the powders, pulverization is carried out, and the powder particle size after the pulverization should better be as fine as possible, and it is particularly preferred to employ a wet method whereby uniform mixing, high dispersion and fine pulverization can be carried out simply and efficiently. At that time, in a case where a ball mill, a beads mill, an attritor, a vibration mill, a planetary mill or a jet mill, etc. is used in a wet system, the slurry after the pulverization is required to be dried. The drying method is not particularly limited, and for example, filtration drying, fluidized bed drying or spray drying may be exemplified.

Further, in the case of mixing powders other than oxides, it is preferred that after the mixing, the mixture is calcined at a temperature of from 500 to 1,200°C, and the obtained calcined powder is pulverized and then used. It is thereby possible to prevent breakage such as cracking or chipping when molded and fired in subsequent steps. The purity of each raw material powder is usually at least 99%, preferably at least 99.9%, more preferably at least 99.99%. If the purity is low, due to impurities, adverse influences are likely to be observed to the properties of a transparent conductive film formed by the sputtering target prepared by using the oxide sintered body of the present invention.

The blend ratio of these raw materials will be reflected to the atomic ratio of elements constituting an oxide sintered body to be obtained, and therefore, raw materials are mixed so that the atomic ratio of zinc and element X would be $0.0001 \leqq X/(Zn+X) \leqq 0.20$. The raw materials are mixed so that the atomic ratio would be more preferably $0.10 \leqq X/(Zn+X) \leqq 0.20$, further preferably $0.15 \leqq X/(Zn+X) \leqq 0.20$.

The mixed powder (when calcined, the calcined mixed powder) thus obtained, is preferably adjusted before molding so that the primary particle size would be at most 1 μm, such adjustment being preferred particularly in the case of calcined mixed powder. It is more preferred to carry out granulation, whereby it becomes possible to increase the flowability during molding, and the productivity will be excellent. The granulation method is not particularly limited, and spray drying granulation or tumbling granulation may be exemplified. Usually, granulated powder to be used, has an average particle size of a few μm to 1,000 μm.

(2) Molding step

The molding method is not particularly limited so long as the mixed powder (when calcined, the mixed calcined powder) of metal oxides can be molded into a desired shape. A press molding method, a cast molding method or an injection molding method may be exemplified. The molding pressure is not particularly limited, so long as a molded product with good handling efficiency is obtainable without cracking, etc. However, when the mixed powder is molded at a relatively high molding pressure, e.g. at a level of from 500 kg/cm$^2$ to 3.0 ton/cm$^2$ in the case of press molding, an oxide sintered product of the present invention wherein no oxide particles of element X are present, tends to be readily obtainable, and one having a sintered density of at least 95% tends to be readily obtainable. Further, the molded density should better be as high as possible. For such a purpose, it is possible to use such a molding method as cold isostatic pressing (CIP). Further, at the time of molding, a molding aid such as polyvinyl alcohol, an acrylic polymer, methyl cellulose, a wax or oleic acid, may be used.

(3) Sintering step

Then, the obtained green body is fired at a temperature of from 1,050 to 1,500°C. By firing within this temperature range, it is possible to obtain an oxide sintered body composed of particles having a fine average particle size. Particularly, with a view to preventing volatilization dissipation specific to zinc oxide and increasing the sintered density, the firing temperature is more preferably within a range of from 1,050 to 1,450°C. Further, when the firing temperature is adjusted to be from 1,200 to 1,450°C, one wherein no oxide particles of element X are present, tends to be readily obtainable, and one having a sintered density of at least 95% tends to be readily obtainable.

Further, in a case where a molding aid is used at the time of molding, it is preferred to add a degreasing step before firing, in order to prevent breakage such as cracking during heating.

According to the present invention, by controlling the average particle size of particles constituting the oxide sintered body as mentioned above, it is possible to obtain a high sintered density, and when used as a target, it is possible to remarkably prevent an abnormal discharge phenomenon during sputtering.

The firing time is not particularly limited, and it is usually from 1 to 48 hours, preferably from 3 to 24 hours, although it may depend on the firing temperature. This is to secure the homogeneity in the oxide sintered body of the present invention. Although it is possible to secure the homogeneity even when held at a longer time than 24 hours, but the firing time of at most 24 hours is sufficient in consideration of the influence to the productivity. Further, in order to obtain an oxide sintered body composed of particles having a fine average particle size, the firing time is particularly preferably from 3 to 10 hours.

The temperature raising rate is not particularly limited, and in a temperature range of at least 800°C, it is preferably at most 200°C/hr. This is to secure the homogeneity in the oxide sintered body of the present invention.

The firing atmosphere is not particularly limited, and it may be selected from, for example, in atmospheric air, in oxygen or in an inert gas atmosphere. Further, the pressure during firing is also not particularly limited, and in addition to ordinary pressure, firing in an elevated or reduce pressure state is possible. Also firing by a hot isostatic press (HIP) method is possible.

Further, (2) molding step and (3) firing step may be simultaneously carried out. That is, it is possible to prepare the oxide sintered body by e.g. a hot press method wherein the powder prepared in the powder preparation step is filled into a die for molding, followed by firing, or a method wherein the same powder is melted and sprayed at a high temperature into a predetermined shape.

EXAMPLES

Now, the present invention will be described specifically with reference to Examples and Comparative Examples, but it should be understood that the present invention is by no means thereby limited.

(Preparation of solar cell, and evaluation methods)

Firstly, on soda lime glass 1, Mo was laminated in 400 nm by sputtering to prepare a lower electrode 2. As a p-type semiconductor layer 3, a CuGa/In/Se precursor was formed by a sputtering method, and then, the CuGa/In/Se precursor was heated to from about 450 to 550°C, so that by solid phase diffusion, a Cu(Ga, In)Se$_2$ film was formed. Then, on the above CIGS surface, a n-type semiconductor layer 4 was formed by a sputtering target. Then, by a magnetron sputtering method, an ITO (Indium Tin Oxide) transparent conductive film of a surface electrode layer 5 was formed and an antireflective film MgF$_2$ was formed, and then, as an extraction electrode 7, NiCr and Au were co-vapor deposited and used.

The obtained solar cell was irradiated with light of AM1.5 (100 mW/cm$^2$) by a solar simulator, whereby the current-voltage characteristics were measured, and the short-circuiting current, open voltage, fill factor and photoelectric conversion efficiency were evaluated and relatively compared.

Here, during the light irradiation, the current at which both electrodes were shortcircuited, is referred to as the short-circuiting current, and the output voltage when both electrodes were open, is referred to as the open voltage, and one obtained by dividing the short-circuiting current by an effective light-receiving area, is referred to as the short-circuiting current density. The product of the short-circuiting current and the open voltage is the value of electric power which can be ideally taken out by this solar cell, and the fill factor (FF) represents the ratio of the electric power which can be practically taken out, to this value. Accordingly, the larger the values of the short-circuiting current, open voltage, fill factor and conversion efficiency, the better the properties of the solar cell.

The physical properties of the obtained films are shown in Table 2, and the results of the characteristics of the prepared solar cells are shown in Table 3 by calculating them as relative values to the value obtained in Comparative Example 1 being 1.00.

(Raw material powders)

The physical properties of the raw material powders used are as shown in Table 1.

Table 1

| Type of powder | Purity (%) | BET specific surface area (m$^2$/g) | Average particle size ($\mu$m) | Ionization potential (eV) | Atomic radius (Å) |
|---|---|---|---|---|---|
| Zinc oxide | 99.8 | 4.0 | 2.4 | - | - |
| Magnesium oxide | 99.8 | 5.0 | 2.7 | 7.65 | 1.45 |
| Strontium carbonate | 99.9 | 14.0 | 1.6 | 5.69 | 2.19 |

(continued)

| Type of powder | Purity (%) | BET specific surface area (m²/g) | Average particle size (μm) | Ionization potential (eV) | Atomic radius (Å) |
|---|---|---|---|---|---|
| Zirconium oxide | 99.9 | 12.0 | 1.6 | 6.63 | 2.06 |
| Calcium carbonate | 99.9 | 8.0 | 1.8 | 6.11 | 1.94 |
| Titanium oxide | 99.9 | 7.5 | 1.3 | 6.83 | 1.76 |
| Barium carbonate | 99.9 | 9.2 | 1.4 | 5.21 | 2.53 |
| Tantalum oxide | 99.9 | 6.9 | 1.9 | 7.55 | 2.00 |
| Lanthanum oxide | 99.9 | 6.5 | 2.2 | 5.58 | 1.95 |
| Neodium oxide | 99.9 | 7.3 | 1.7 | 5.52 | 2.06 |
| Europium oxide | 99.9 | 6.8 | 2.1 | 5.67 | 2.31 |
| Holmium oxide | 99.9 | 7.9 | 2.0 | 6.02 | 2.26 |

Further, the raw material powders were evaluated as follows.

(BET specific surface area)

Measured by a single point BET method by using MONOSORB (manufactured by QUANTACHROME INSTRUMENTS, USA).

(Average particle size)

Measured by means of a liquid module in distilled water by using COULTER LS130 (manufactured by COULTER ELECTRONICS). The measured value is volume-based.

(Example 1)

Zinc oxide powder and magnesium oxide powder were mixed and pulverized by a wet system beads mill and dried so that the ratio in number of atoms of zinc and calcium would be a value as shown in Table 2, then filled in a die having a diameter of 150 mm, followed by uniaxial press-molding under a pressure of 300 kg/cm², and then CIP-molded under 3.0 ton/cm². The obtained green product was fired under conditions of a temperature raising rate of 50°C/hr, a temperature lowering rate of 100°C /hr, a firing temperature of 1,200°C, a retention time of 3 hours in nitrogen, to obtain an oxide sintered body. Example 1 is a Reference Example.

(Examples 2 to 16 and Comparative Examples 1 to 6)

An oxide sintered body was obtained in the same manner as in Example 1 except that powders used, were changed so that the composition of the sintered body would be the values as shown in Table 2. Further, only in Comparative Example 2, the firing temperature was changed to 1,000°C. Examples 2, 12 and 13 are Reference Examples.

• Oxide sintered body and characteristics of sputtering target

(Density of oxide sintered body)

A prepared sintered body was boiled in water, whereupon the sintered density was measured by an Archimedes method.

(Production method for sputtering target)

A prepared sintered body was processed into a predetermined shape and used as a sputtering target. The surface of the target to be a sputtering surface, was processed by means of a surface grinding machine and a diamond whetstone.

• Film deposition method, characteristics of oxide film

(Sputtering conditions by sputtering target)

• Apparatus: RF magnetron sputtering apparatus (manufactured by ULVAC)
• Magnetic field intensity: 1,000 Gauss (immediately above the target, horizontal component)
• Substrate temperature: room temperature
• Reached vacuum degree: $5 \times 10^{-5}$Pa
• Sputtering gas: argon
• Sputtering gas pressure: 1.0 Pa
• DC power: 25 W/4inch$\phi$
• Film thickness: 80 nm

The composition, electrical resistance and optical characteristics of a film were measured by the following methods by using a sample deposited on a glass substrate under the same conditions as above.

(Composition of thin film)

Quantitative analysis was conducted by an ICP emission spectrometric analysis by means of an ICP emission spectrophotometer (manufactured by Seiko Instruments Inc.)

(Electrical resistance of thin film)

The electrical resistance of a thin film was measured by means of Hiresta UP MCP-HT450 Model (manufactured by Mitsubishi Chemical Analytech Co., Ltd.)

(Transmittance of thin film)

The light transmittance including the substrate was measured by a spectrophotometer U-4100 (manufactured by Hitachi, Ltd.), whereby the average value in transmittance of wavelengths from 400 nm to 800 nm was taken as the transmittance in the visible light region, and the average value in transmittance of wavelengths from 800 nm to 1,200 nm was taken as the transmittance in the infrared region. The transmittance is defined by the following formula.

$$\text{Transmittance (\%)} = (\text{Amount of light passed/amount of light entered}) \times 100$$

From the foregoing results, it has been found that the oxide sintered body of the present invention is suitable as a sputtering target to be used for preparation of an n-type semiconductor layer in the preparation of a solar cell, and the obtained solar cell has high conversion efficiency as compared with conventional solar cells.

Table 2; * indicates Reference Examples

| | Raw material powder composition (atomic ratio) | | | Sintered density (%) |
|---|---|---|---|---|
| | Zn/(Zn+X) | Element X | X/(Zn+X) | |
| Ex. 1* | 0.850 | Ca | 0.150 | 99.1 |
| Ex. 2* | 0.850 | Sr | 0.150 | 99.0 |
| Ex. 3 | 0.842 | Mg, Sr | 0.158 (Mg:Sr=15:0.8) | 99.2 |
| Ex. 4 | 0.849 | Mg, Sr | 0.151 (Mg:Sr=15:0.1) | 99.1 |
| Ex. 5 | 0.849 | Mg, Ca | 0.151 (Mg:Ca=15:0.1) | 99.1 |
| Ex. 6 | 0.849 | Mg, Ti | 0.151 (Mg:Ti=15:0.1) | 98.9 |
| Ex. 7 | 0.849 | Mg, La | 0.151 (Mg:La=15:0.1) | 99.0 |
| Ex. 8 | 0.849 | Mg, Eu | 0.151 (Mg:Eu=15:0.1) | 98.9 |
| Ex. 9 | 0.849 | Mg, Ta | 0.151 (Mg:Ta=15:0.1) | 98.9 |
| Ex. 10 | 0.971 | Mg, Sr | 0.029 (Mg:Sr=2.0:0.9) | 99.0 |
| Ex. 11 | 0.949 | Mg, Sr | 0.051 (Mg:Sr=5.0:0.1) | 99.4 |
| Ex. 12* | 0.840 | Ca, Sr | 0.160 (Ca:Sr=14:2) | 99.3 |
| Ex. 13* | 0.900 | Ca, Sr | 0.100 (Ca:Sr=4:6) | 99.0 |
| Ex. 14 | 0.849 | Mg, Zr | 0.151 (Mg:Zr=15:0.1) | 98.9 |
| Ex. 15 | 0.849 | Mg, Nd | 0.151 (Mg:Nd=15:0.1) | 98.9 |
| Ex. 16 | 0.849 | Mg, Ho | 0.151 (Mg:Ho=15:0.1) | 99.0 |
| Comp. Ex. 1 | 0.850 | Mg | 0.150 | 99.2 |
| Comp. Ex. 2 | 0.850 | Mg, Sr | 0.150 (Mg:Sr=15:0.1) | 93.2 |
| Comp. Ex. 3 | 0.750 | Mg, Sr | 0.250 (Mg:Sr=24.9:0.1) | 98.7 |
| Comp. Ex. 4 | 0.750 | Mg, Sr | 0.250 (Mg:Sr=12:13) | 99.1 |
| Comp. Ex. 5 | 0.849 | Mg, Ba | 0.151 (Mg:Ba=15:0.1) | 98.1 |
| Comp. Ex. 6 | 1.000 | - | 0 | 98.1 |

Table 2 (Continued) ; * indicates Reference Examples

| | Film characteristics | | | | |
|---|---|---|---|---|---|
| | Composition (atomic ratio) | | Transmittance (%) in visible region of from 450 to 800 nm | Transmittance (%) in near infrared region of from 800 to 1,200 nm | Sheet resistance |
| | Zn/(Zn+X) | X/(Zn+X) | | | $(\Omega/\square)$ |
| Ex. 1* | 0.852 | 0.148 | 84 | 90 | 4.40E+10 |
| Ex. 2* | 0.851 | 0.149 | 84 | 91 | 4.60E+10 |
| Ex. 3 | 0.846 | 0.154 (Mg:Sr=14.8:0.6) | 84 | 90 | 3.00E+10 |
| Ex. 4 | 0.852 | 0.148 (Mg:Sr=14.73:0.07) | 83 | 90 | 3.20E+10 |
| Ex. 5 | 0.853 | 0.147 (Mg:Ca=14.64:0.06) | 83 | 89 | 4.50E+10 |
| Ex. 6 | 0.852 | 0.148 (Mg:Ti=14.74:0.06) | 85 | 90 | 5.20E+10 |
| Ex. 7 | 0.852 | 0.148 (Mg:Eu=14.75:0.05) | 84 | 91 | 3.90E+10 |
| Ex. 8 | 0.852 | 0.148 (Mg:La=14.74:0.06) | 84 | 90 | 4.10E+10 |
| Ex. 9 | 0.852 | 0.148 (Mg:Ta=14.74:0.07) | 85 | 91 | 4.00E+10 |
| Ex. 10 | 0.972 | 0.0282 (Mg:Sr=2.02:0.8) | 83 | 91 | 9.30E+08 |
| Ex. 11 | 0.951 | 0.0494 (Mg:Sr=4.86:0.08) | 82 | 90 | 2.50E+09 |
| Ex. 12* | 0.844 | 0.156 (Ca:Sr=13.7:1.9) | 82 | 88 | 7.60E+09 |
| Ex. 13* | 0.901 | 0.099 (Ca:Sr=3.9:6.0) | 82 | 89 | 1.20E+10 |
| Ex. 14 | 0.852 | 0.148 (Mg:Ta=14.74:0.06) | 85 | 91 | 3.00E+10 |
| Ex. 15 | 0.852 | 0.148 (Mg:Nd=14.74:0.07) | 84 | 90 | 4.80E+10 |
| Ex. 16 | 0.852 | 0.148 (Mg:Ho=14.74:0.07) | 84 | 91 | 5.40E+10 |
| Comp. Ex. 1 | 0.852 | 0.148 | 83 | 89 | 7.80E+10 |
| Comp. Ex. 2 | 0.852 | 0.148 (Mg:Sr=14.73:0.06) | 82 | 89 | 6.80E+09 |
| Comp. Ex. 3 | 0.748 | 0.252 (Mg:Sr=25.11:0.09) | 78 | 87 | 3.70E+09 |
| Comp. Ex. 4 | 0.749 | 0.251 (Mg:Sr=12:13.1) | 77 | 88 | 3.80E+09 |
| Comp. Ex. 5 | 0.852 | 0.148 (Mg:Sr=14.74:0.06) | 83 | 91 | 3.30E+10 |
| Comp. Ex. 6 | 1.000 | 0 | 82 | 91 | 2.10E+08 |

Table 3; * indicates Reference Examples

|  | Solar cell characteristics | | | |
|  | Short-circuiting current | Open voltage | Fill factor | Conversion efficiency |
| --- | --- | --- | --- | --- |
| Ex. 1* | 1.02 | 1.04 | 1.00 | 1.06 |
| Ex. 2* | 1.00 | 1.05 | 1.03 | 1.08 |
| Ex. 3 | 1.04 | 1.17 | 1.07 | 1.30 |
| Ex. 4 | 1.03 | 1.23 | 1.07 | 1.36 |
| Ex. 5 | 1.05 | 1.18 | 1.07 | 1.33 |
| Ex. 6 | 1.14 | 1.08 | 1.03 | 1.27 |
| Ex. 7 | 1.43 | 0.80 | 1.05 | 1.20 |
| Ex. 8 | 1.40 | 0.95 | 1.02 | 1.36 |
| Ex. 9 | 1.01 | 1.07 | 1.03 | 1.11 |
| Ex. 10 | 1.00 | 1.01 | 1.02 | 1.03 |
| Ex. 11 | 1.02 | 1.03 | 1.01 | 1.06 |
| Ex. 12* | 1.03 | 1.04 | 1.02 | 1.09 |
| Ex. 13* | 1.04 | 1.06 | 1.03 | 1.14 |
| Ex. 14 | 1.02 | 1.04 | 1.01 | 1.20 |
| Ex. 15 | 1.15 | 1.06 | 1.03 | 1.30 |
| Ex. 16 | 1.17 | 1.07 | 1.02 | 1.33 |
| Comp. Ex. 1 | 1.00 | 1.00 | 1.00 | 1.00 |
| Comp. Ex. 2 | 1.01 | 0.93 | 0.95 | 0.89 |
| Comp. Ex. 3 | 0.96 | 1.02 | 0.99 | 0.97 |
| Comp. Ex. 4 | 0.93 | 1.05 | 0.98 | 0.96 |
| Comp. Ex. 5 | 0.99 | 0.97 | 1.02 | 0.98 |
| Comp. Ex. 6 | 0.97 | 0.90 | 0.98 | 0.86 |

According to the present invention, it becomes possible to improve the conversion efficiency of a compound thin film solar cell and to increase the amount of energy to be utilized.

REFERENCE SYMBOLS

1: Substrate

2: Lower electrode film

3: p-type semiconductor layer

4a: n-type buffer layer

4b: n-type semiconductor layer

5: Upper electrode film

6: Antireflective film layer

7: Extraction electrode

## Claims

1. An oxide sintered body which contains zinc (Zn) and magnesium (Mg) and at least one type of element X that has an ionization potential Ip of $4.5\ eV \leqq Ip \leqq 8.0\ eV$ and an atomic radius d of $1.20\ \text{Å} \leqq d \leqq 2.50\ \text{Å}$ and which has a sintered density of at least 95%, wherein
   the element X is at least one element selected from the group consisting of Li, Ca, Sc, Ti, Sr, Y, Zr, Nb, La, Ce, Nd, Sm, Eu, Ho, Hf, Ta, W and Bi in the following composition ratios (atomic ratios):

$$0.0001 \leq X/(Zn+Mg+X) \leq 0.01$$

$$0.0002 \leq (Mg+X)/(Zn+Mg+X) \leq 0.20.$$

2. A sputtering target using the sintered body as defined in Claim 1.

3. An oxide thin film obtainable by using the sputtering target as defined in Claim 2.

4. A photoelectric conversion element which is a solar cell having a light-absorbing layer being a p-type semiconductor, and a n-type semiconductor layer, wherein the n-type semiconductor layer is the oxide thin film as defined in Claim 3.

5. A method for producing the photoelectric conversion element as defined in Claim 4, which comprises forming the n-type semiconductor layer by using the sintered body as defined in Claim 2 as a sputtering target.

## Patentansprüche

1. Oxidsinterkörper, der Zink (Zn) und Magnesium (Mg) und mindestens einen Elementtyp X enthält, welches ein Ionisationspotential Ip von $4,5\ eV \leqq Ip \leqq 8,0\ eV$ und einen Atomradius d von $1,20\ \text{Å} \leqq d \leqq 2,50\ \text{Å}$ aufweist und der eine Sinterdichte von mindestens 95% aufweist, wobei
   das Element X mindestens ein Element, ausgewählt aus der Gruppe bestehend aus Li, Ca, Sc, Ti, Sr, Y, Zr, Nb, La, Ce, Nd, Sm, Eu, Ho, Hf, Ta, W und Bi in den folgenden Zusammensetzungsverhältnissen (Atomverhältnissen), ist:

$$0,0001 \leq X/(Zn+Mg+X) \leq 0,01$$

$$0,0002 \leq (Mg+X)/(Zn+Mg+X) \leq 0,20.$$

2. Sputtertarget, verwendend den Sinterkörper nach Anspruch 1.

3. Oxiddünnfilm, erhältlich durch Verwenden des Sputtertargets nach Anspruch 2.

4. Photoelektrisches Umwandlungselement, das eine Solarzelle mit einer lichtabsorbierenden Schicht, die ein Halbleiter des p-Typs ist, und einer Halbleiterschicht des n-Typs ist, wobei die Halbleiterschicht des n-Typs der Oxiddünnfilm nach Anspruch 3 ist.

5. Verfahren zur Herstellung des photoelektrischen Umwandlungselements nach Anspruch 4, welches das Bilden der Halbleiterschicht des n-Typs durch das Verwenden des Sinterkörpers nach Anspruch 2 als ein Sputtertarget umfasst.

## Revendications

1. Corps fritté d'oxyde qui contient du zinc (Zn) et du magnésium (Mg) et au moins un type d'élément X qui présente un potentiel d'ionisation Ip de **4.5 eV≦Ip≦8.0 eV** et un rayon atomique d de **1.20 Å≦d≦2.50 Å** et qui a une densité frittée d'au moins 95%, dans lequel

l'élément X est au moins un élément sélectionné parmi le groupe consistant en Li, Ca, Sc, Ti, Sr, Y, Zr, Nb, La, Ce, Nd, Sm, Eu, Ho, Hf, Ta, W et Bi dans les rapports de composition (rapports atomiques) suivants:

$$0.0001 \leq X/(Zn+Mg+X) \leq 0.01$$

$$0.0002 \leq (Mg+X)/(Zn+Mg+X) \leq 0.20.$$

2. Cible de pulvérisation utilisant le corps fritté selon la revendication 1.

3. Film mince d'oxyde qu'on peut obtenir en utilisant la cible de pulvérisation selon la revendication 2.

4. Élément de conversion photoélectrique qui est une cellule solaire présentant une couche absorbant la lumière qui est un semi-conducteur de type p et une couche semi-conductrice de type n, dans lequel la couche semi-conductrice de type n est le film mince d'oxyde selon la revendication 3.

5. Procédé de production de l'élément de conversion photoélectrique selon la revendication 4, qui comprend la formation de la couche semi-conductrice de type n en utilisant le corps fritté selon la revendication 2 comme cible de pulvérisation.

Fig. 1

Fig. 2

**EP 2 921 467 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009132998 A

- JP 2003197935 A

**Non-patent literature cited in the description**

- **E CLEMENTI ; DL RAIMONDI ; WP REINHARDT.** *J. Chem. Phys.,* 1963, vol. 38, 2686